# EUROPÄISCHE PATENTSCHRIFT

(11) **EP 2 169 700 B1**
(45) Veröffentlichungstag und Bekanntmachung des Hinweises auf die Patenterteilung: **09.11.2011**
(21) Anmeldenummer: 09163275.2
(22) Anmeldetag: 19.06.2009
(51) Int. Cl.: H01H 47/00

(54) **Verfahren und Vorrichtung zur Überwachung eines Schaltvorganges und Relaisbaugruppe**
Method and device for monitoring a switching procedure and relay component group
Procédé et dispositif de surveillance d'un processus de commutation et composant de relais

(30) Priorität: 26.09.2008 WO PCT/EP2008/008359
(43) Veröffentlichungstag der Anmeldung: 31.03.2010
(73) Patentinhaber: SIEMENS AKTIENGESELLSCHAFT, 80333 München (DE)
(72) Erfinder: Fischer, Peter, 92421, Schwandorf (DE)

(56) Entgegenhaltungen:
- DE-U1- 8 504 729
- FR-A1- 2 565 430
- US-B1- 6 233 132

## Beschreibung

Die Erfindung betrifft ein Verfahren zur Überwachung eines Schaltvorganges eines Schaltelementes zum Schalten eines elektrischen Stromes für einen Verbraucher.

Ebenso betrifft die Erfindung eine Vorrichtung zur Überwachung eines Schaltvorganges eines Schaltelementes zum Schalten eines elektrischen Stromes für einen Verbraucher.

Des Weiteren betrifft die Erfindung eine Relaisbaugruppe mit einer Vorrichtung zur Überwachung eines Schaltvorganges.

Das Dokument FR 2565430 offenbart ein Verfahren gemäß dem Oberbegriff des Anspruchs 1.

Eine Relaisbaugruppe, vorzugsweise für den Einsatz bei einer speicherprogrammierbaren Steuerung, kann mittels Schaltelementen, vorzugsweise metallisch ausgeführten Kontakten, aber auch insbesondere in Halbleitertechnik ausgeführte Schaltelemente, einen an einen Schaltausgang der Relaisbaugruppe angeschlossenen Verbraucher schalten. Der angeschlossene Verbraucher kann beispielsweise eine Signallampe, ein Motor, ein Förderband, ein galvanisches Bad oder eine Hochspannungsanlage sein. Beim Schalten der genannten Verbraucher, insbesondere bei Verbrauchern mit einem hohen Strombedarf, insbesondere Einschaltstrombedarf, werden das Schaltelement bzw. die metallischen Schaltkontakte während des Schaltvorganges stark beansprucht. Diese Beanspruchung führt zu einem schleichenden Verschleiß des Schaltelementes. Ist das Schaltelement als ein metallisches Kontaktpaar ausgestaltet, so wird sich im Laufe der Zeit eine Außenschicht der Kontakte verschlechtern, beispielsweise durch Abbrand der Oberfläche oder durch Korrosion. Dies bedeutet, dass wenn eine maximale Anzahl von Schaltspielen überschritten wird, dies zu einer Störung bzw. zur Beschädigung der Kontakte führt. Aus Sicht eines Anwenders, beispielsweise in der Automatisierungstechnik, bedeutet eine Beschädigung einer Relaisbaugruppe Reparaturzeiten und Stillstandszeiten einer elektrischen Anlage, welches sich nachteilig auf beispielsweise eine Produktion von Gütern auswirkt.

Bei Relaisbaugruppen nach dem Stand der Technik ist es bekannt, eine definierte maximale Anzahl von Schaltspielen vorzugeben, wobei der Hersteller in der Regel mit dieser vorgebbaren maximalen Anzahl von Schaltspielen eine einwandfreie Funktion der Relaisbaugruppe garantiert. Diese vorgebbare maximale Anzahl an Schaltspielen ist aber eine Schätzung. Es kann durchaus vorkommen, dass ein Schaltelement bereits vor Erreichen der maximalen Anzahl von Schaltspielen verschließen ist oder es kann auch vorkommen, dass ein Schaltelement weit über die angegebene maximale Anzahl von Schaltspielen störungsfrei betrieben werden kann.

Es ist daher die Aufgabe der vorliegenden Erfindung, ein Verfahren anzugeben, welches es ermöglicht eine verbesserte Aussage über die mögliche maximale Schaltspielanzahl eines Schaltelementes anzugeben.

Die Aufgabe wird durch das eingangs genannte Verfahren dadurch gelöst, dass zumindest ein individueller Verbrauchswert des Verbrauchers ermittelt wird, der Verbrauchswert mit einem Referenzwert verglichen wird, und in Abhängigkeit eines Vergleichsergebnisses eine Vorhersage für eine maximale Schaltspielanzahl gegeben wird. Es ist hierbei von Vorteil, dass die individuellen Verbrauchswerte der angeschlossenen Lasten berücksichtigt werden, so kann beispielsweise bei einem angeschlossenen Motor davon ausgegangen werden, dass er beispielsweise bei einem Sanftanlauf andere individuelle Verbrauchswerte liefert als bei einem Schwerlastanlauf. Abhängig von diesem unterschiedlichen Betrieb wird auch das Schaltelement unterschiedlich beansprucht. Eine Lebensdauer des beispielsweise mechanischen Kontaktes ist unter anderem abhängig von: Einer zu schaltenden Spannung, beispielsweise einer Wechselspannung oder einer Gleichspannung, einer Höhe der Spannung, einer zuschaltenden Last, wie einer ohmschen Last, einer induktiven Last oder einer kapazitiven Last, einem Einschaltstrom und einem Ausschaltstrom. Ein Kontaktverschleiß des Schaltelementes ist demnach von vielen Größen abhängig und diese Größen wirken sich entscheidend auf die Lebensdauer des Schaltelementes aus. Durch den Vergleich der ermittelten Verbrauchswerte mit Referenzwerten, welche bei definierten Strom- und Spannungsverhältnissen aufgenommen wurden, kann eine Prognose über einen möglichen Verschleiß des Schaltelementes genauer bestimmt werden.

Zweckmäßig ist es, wenn ein zeitlicher Verlauf des Stromes ermittelt wird. Anhand eines charakteristischen Kurvenverlaufes des Stromes eines Verbrauchers können erste Aussagen über seine elektrische Beschaffenheit, wie beispielsweise eine vorrangig induktive Last oder eine vorrangig kapazitive Last, gemacht werden.

Weiterhin ist es dabei zweckmäßig, einen zeitlichen Verlauf einer Spannung am Verbraucher zu ermitteln. Die Kenntnis vom zeitlichen Verlauf des Stromes und der Spannung lassen eine Genauigkeit einer Aussage über den Verbraucher weiterhin ansteigen.

Dabei ist es von besonderem Vorteil, wenn der zeitliche Verlauf des Stromes und/oder der Spannung abschnittsweise analysiert wird und eine Aussage über einen möglichen Verschleiß des Schaltelementes gegeben wird.

Das Verfahren wird weiterhin optimiert, wenn charakteristische Daten des Verbrauchers ermittelt und gespeichert werden. Das verfahrensmäßige Hinterlegen der charakteristischen Daten entspricht einer "Teach-in-Funktion", das Verfahren ist somit dazu geeignet, während der Durchführung, geänderte Vorraussetzungen zu erkennen und sich diesen anzupassen.

In einer weiteren Ausgestaltung der Erfindung wird das Erreichen einer vorgebbaren ersten Anzahl oder der maximalen Schaltspielanzahl überwacht, und bei Überschreiten einer der beiden Anzahlen eine Warnung ausgegeben. Da je nach Einsatz einer Schaltvorrichtung, bei welcher das Verfahren angewendet wird, unterschiedliche Lasten geschaltet werden können, wird sich eine Hochrechnung für die maximale Schaltspielanzahl abhängig vom Einsatz ständig ändern. Wurden beispielsweise die letzten 100 Schaltvorgänge mit einer hohen Belastung für das Schaltelement durchgeführt, so wird die Prognose für die maximale Schaltspielanzahl einer "worst case" Grenze nähern. Wurden hingegen die letzten 100 Schaltvorgänge quasi ohne nennenswerte Last durchgeführt, so wird sich die maximale Schaltspielanzahl in Richtung eines "best case" Wertes bewegen.

Um eine Zerstörung des Schaltelementes zu vermeiden oder um eine unsichere Schaltverbindung zu vermeiden, wird zweckmäßiger Weise bei Überschreiten einer der beiden Anzahlen ein wiederholtes Schalten verhindert.

In einer bevorzugten Ausgestaltung wird zur kontaktlosen Messung des elektrischen Stromes ein magnetoresistiver Sensor eingesetzt.

Weiterhin wird zur Messung der Spannung bevorzugt ein mikro-elektro-mechanisches System zur Messung eingesetzt. Ein MEMS-Voltmeter findet in diesem Verfahren Anwendung.

Die eingangs genannte Vorrichtung löst die eingangs genannte Aufgabe ebenfalls dadurch, dass die Vorrichtung ein Ermittlungsmittel zum Ermitteln zumindest eines individuellen Verbrauchswertes des Verbrauchers, ein Vergleichsmittel zum Vergleichen des zumindest einen Verbrauchswertes mit einem Referenzwert und ein Vorhersagemittel zum Vorhersagen einer maximalen Schaltspielanzahl in Abhängigkeit des Vergleichsergebnisses aufweist. Insbesondere bei Sicherheitsschaltgeräten, welche eine funktionale Sicherheit gewährleisten müssen, beispielsweise nach der Norm IEC 61508, kann eine derartige Vorrichtung mit großem Nutzen eingesetzt werden. Bisher mussten sich Anwender von beispielsweise Relaisbaugruppen in der Sicherheitstechnik nach einem B10-Wert richten. Für verschleißbehaftete Geräte entspricht der B10-Wert den Schaltspielen. Mit der Vorrichtung ist es nun möglich, eine maximale Schaltspielanzahl nicht statisch auszuwerten, sondern auf die gegebenen Einsatzbedingungen angemessen reagieren zu können. Beispielsweise könnte die Vorrichtung auch eine Rückmeldung zu einem übergeordneten Leitsystem geben und eine frühzeitige Warnung zum Austausch eines Schaltelementes veranlassen.

Die Vorrichtung ist weiterhin gemäß den Merkmalen der Ansprüche 12 bis 15 ausgestaltet, wobei sich im Wesentlichen die bereits für das Verfahren genannten Vorteile ergeben.

Auch eine Relaisbaugruppe mit einer Vorrichtung zur Überwachung eines Schaltvorganges eines Schaltelementes zum Schalten eines elektrischen Stromes für einen Verbraucher nach einem der Ansprüche 1 bis 10 löst die eingangs genannte Aufgabe.

Weitere Vorteile und Merkmale werden anhand der Zeichnung erläutert. Es zeigen:
- FIG 1: ein Ausführungsbeispiel einer Relaisbaugruppe mit einer Vorrichtung zur Überwachung eines Schaltvor- ganges,
- FIG 2: eine schematische Skizze zur Verdeutlichung der Funktionsweise eines mikro-elektro-mechanisches System, MEMS-Voltmeter,
- FIG 3: eine weitere schematische Skizze zur weiteren Ver- deutlichung des mikro-elektro-mechanisches Systems und
- FIG 4: ein Ausführungsbeispiel eines mikro-elektro-mecha- nischen Systems.

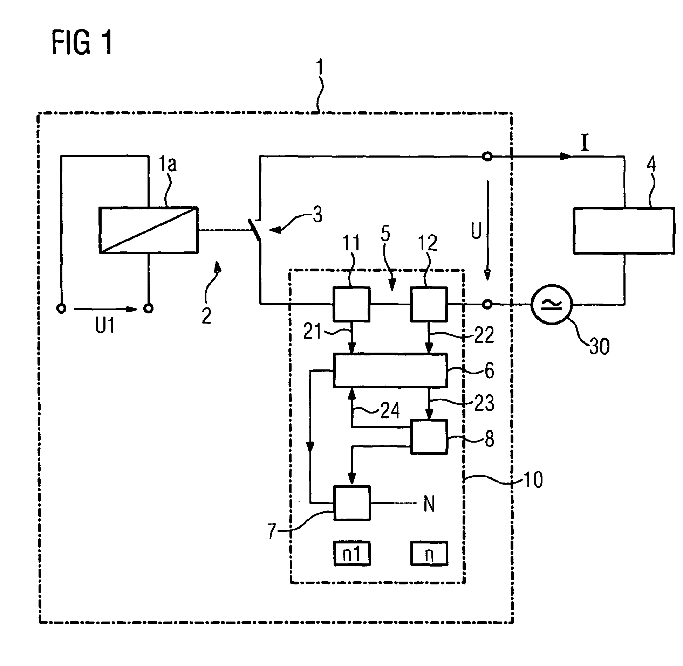

Gemäß der Figur 1 ist eine Relaisbaugruppe 1 dargestellt, wobei die Relaisbaugruppe 1 eine Vorrichtung 10 zur Überwachung eines Schaltvorganges eines Schaltelementes 3 zum Schalten eines elektrischen Stromes I für einen Verbraucher 4 aufweist. Der Verbraucher 4 ist über Anschlussklemmen an die Relaisbaugruppe 1 angeschlossen. Eine Spannungsquelle 30 liegt im Stromkreis des Verbrauchers 4, wobei der Stromkreis durch Schließen des Schaltelementes 3 geschlossen wird und die Spannungsquelle 30 einen Strom I durch den Verbraucher 4 treiben kann. Die Spannungsquelle 30 kann als eine Wechselspannungsquelle oder als eine Gleichspannungsquelle ausgestaltet sein.

Das Schaltelement 3 wird mittels einer Relaisspule 1a über eine Wirkverbindung betätigt. Die Relaisspule 1a wird durch Anlegen einer Schaltspannung U1 an einen ersten Relaisspuleneingang und einen zweiten Relaisspuleneingang zum Schalten des Schaltelementes 3 angeregt. Die Relaisspule 1a und das Schaltelement 3 bilden ein Relais 2.

Die Vorrichtung 10 zur Überwachung des Schaltvorganges des Schaltelementes 3 weist ein Ermittlungsmittel 5 zum Ermitteln zumindest eines individuellen Verbrauchswertes des Verbrauchers 4 auf. Das Ermittlungsmittel 5 ist dabei als ein magnetoresistiver Sensor 11 und als ein Mikro-Elektro-Mechanisches System 12 ausgestaltet. Im Folgenden wird für Mikro-Elektro-Mechanisches System 12 auch MEMS-Voltmeter gesagt.

Der magnetoresistive Sensor 11 und das Mikro-Elektro-Mechanische System 12 sind dabei derart an einen den Strom I führenden Leiter angeordnet, dass sie kontaktlos die Verbrauchswerte des Verbrauchers 4 ermitteln können. Der Sensor 11 ist dabei ausgestaltet, den Strom I zu ermitteln und das Mikro-Elektro-Mechanische System 12 ist dazu ausgestaltet die Spannung U zu ermitteln.

Um eine Vorhersage für eine maximale Schaltspielanzahl N in Abhängigkeit eines Vergleichsergebnisses geben zu können weist die Vorrichtung 10 weiterhin ein Vergleichsmittel 6, ein Vorhersagemittel 7 und ein Speichermittel 8 auf. Das Vergleichsmittel 6 steht derart mit dem Sensor 11 und dem mikro-elektro-mechanischen System 12 in Verbindung, dass der Sensor 11 eine erste Eingangsgröße 21 und das MEMS-Voltmeter 12 eine zweite Eingangsgröße 22 für das Vergleichsmittel 6 bereitstellt. Das Vergleichsmittel 6 ist dabei ausgestaltet die individuellen Verbrauchswerte des Verbrauchers 4 zu ermitteln und die Verbrauchswerte mit Referenzwerten zu vergleichen, wobei die Referenzwerte über einen Eingang 24 für Referenzwerte, welcher mit dem Speichermittel 8 in Verbindung steht, dem Vergleichsmittel 6 zugeführt werden.

Die Referenzwerte in dem Speichermittel 8 können bereits vor einer Inbetriebnahme der Relaisbaugruppe 1 in dem Speichermittel 8 hinterlegt werden, es ist aber auch ebenso möglich, dass die Referenzwerte über einen Ausgang für Referenzwerte des Vergleichsmittel 6 dem Speichermittel 8 zur Verfügung gestellt werden. Dabei werden während des Betriebes der Relaisbaugruppe 1 die charakteristischen Daten des Verbrauchers 4 mittels des Sensors 11 und des MEMS-Voltmeter 12 über das Ermittlungsmittel 6 erfasst und in das Speichermittel 8 abgespeichert. Damit ist eine Lernfunktion oder "Teach-in Funktion" mit der Vorrichtung 10 realisiert.

Das Vorhersagemittel 7 liest über eine Verbindung mit dem Ermittlungsmittel 6 vorzugsweise die aktuellen charakteristischen zeitlichen Verläufe des Stromes I und der Spannung U während eines Schaltvorganges ein und bezieht sich, bei einer Vorhersage für eine mögliche maximale Schaltspielanzahl N, auf die in dem Speichermittel 8 abgespeicherten Referenzwerte bzw. Referenzspannungs- und Stromverläufe. Ein Absolutzähler n ist dazu ausgestaltet, fortlaufend jeden Schaltvorgang mitzuzählen. In einem weiteren Speichermittel ist eine vorgebbare erste Anzahl n1 von Schaltspielen abgespeichert. Die Vorrichtung 10 kann so konfiguriert werden, dass bei Erreichen der vorgebbaren ersten Anzahl n1 oder der maximalen Schaltspielanzahl N eine Warnung ausgegeben werden kann. Auch ist es denkbar, die Vorrichtung 10 so zu konfigurieren, dass bei Überschreiten einer der beiden Anzahlen N, n1 ein wiederholtes Schalten des Schaltelementes 3 verhindert wird.

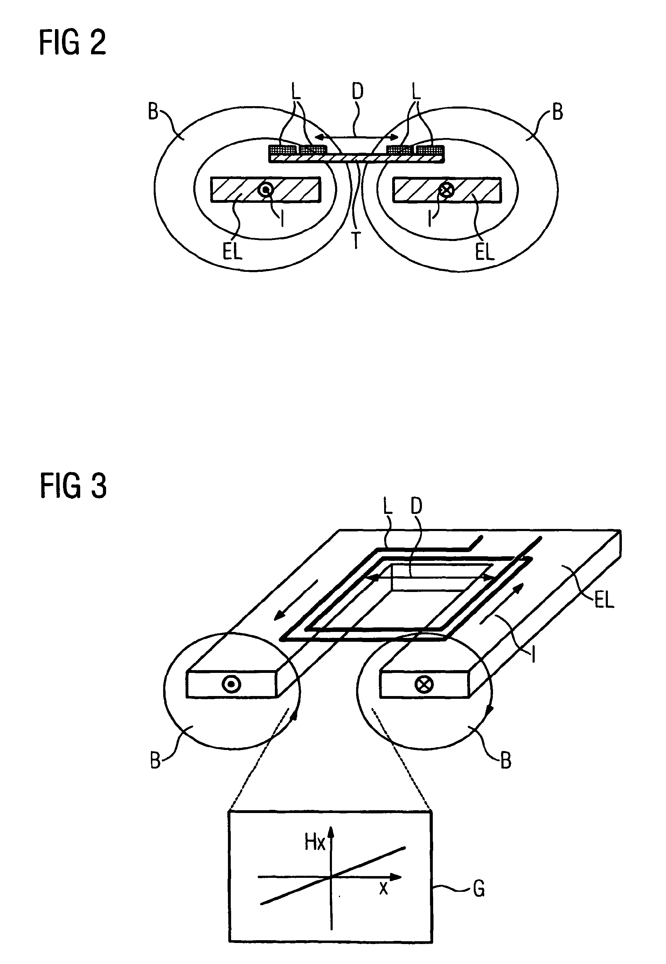

Figur 2 zeigt eine schematische Skizze zur Verdeutlichung der Funktionsweise eines mikro-elektro-mechanisches Systems, MEMS-Voltmeter.

Dargestellt ist ein Querschnitt senkrecht zur Verlaufsrichtung eines elektrischen Leiters EL, der aus einem Hin- und einem Rückleiter besteht. In dem elektrischen Leiter EL fließt ein elektrischer Strom I, dessen Stromrichtung in üblicher Art und Weise angedeutet ist. Aufgrund des in dem elektrischen Leiter EL fließenden Stromes I bildet sich um den elektrischen Leiter EL ein Magnetfeld B aus.

Um nun mittels eines mikroelektromechanischen Systems eine Messgröße für den durch den elektrischen Leiter EL fließenden Strom I erfassen beziehungsweise diesen Strom I quantitativ messen zu können, ist eine Mess-Spule L vorgesehen, die in dem dargestellten Ausführungsbeispiel zwei Windungen aufweist und in flacher Form ausgebildet ist. Die Mess-Spule L ist auf einem Träger T angebracht, der mittels eines aus Gründen der Übersichtlichkeit nicht dargestellten mikromechanischen beziehungsweise mikroelektromechanischen Oszillators derart bewegt wird, dass eine zyklische Änderung des die Mess-Spule L durchsetzenden magnetischen Flusses bewirkt wird. In dem beschriebenen Ausführungsbeispiel erfolgt hierbei ein Schwingen des mikroelektromechanischen Oszillators und damit auch der mit dem Träger T verbundenen Mess-Spule L in der durch den Doppelpfeil angedeuteten Bewegungsrichtung D, d.h. senkrecht zum Verlauf des elektrischen Leiters EL. Aufgrund der durch die Bewegung der Mess-Spule L in dem Magnetfeld B des elektrischen Leiters EL bewirkten Änderung des die Mess-Spule L durchsetzenden magnetischen Flusses wird in der Mess-Spule L eine Spannung induziert, die zu dem durch den elektrischen Leiter EL fließenden elektrischen Strom I proportional ist und damit eine Messgröße für diesen darstellt.

Es sei darauf hingewiesen, dass die Mess-Spule L abweichend von der Darstellung der Figur 1 selbstverständlich auch in einem Magnetfeld eines einzelnen elektrischen Leiters, d.h. nicht zwischen einem Hin- und einem Rückleiter, bewegt werden könnte. Ausgehend von der Darstellung der Figur 1 könnte dies beispielsweise so aussehen, dass der linke Teil des elektrischen Leiters EL in der Darstellung entfällt und der Träger T mit der Mess-Spule L nach rechts verschoben wird, so dass die Mess-Spule L um die Mitte des dann nur einen Leiter aufweisenden elektrischen Leiters EL schwingt. Auch in diesem Fall ergibt sich eine Änderung des die Mess-Spule L durchsetzenden magnetischen Flusses, so dass auch mittels einer solchen Anordnung eine Messgröße für den durch den elektrischen Leiter EL fließenden Strom I erfassbar ist. Die in der Figur 1 dargestellte Ausführungsform weist jedoch den Vorteil auf, dass aufgrund dessen, dass die Mess-Spule L zwischen dem Hin- und dem Rückleiter des elektrischen Leiters EL bewegt wird, die in der Mess-Spule L induzierte Spannung eine größere Amplitude aufweist. Ursache hierfür ist, dass mittels der Bewegung der Mess-Spule L zwischen dem Hin- und dem Rückleiter eine besonders starke Änderung des die Mess-Spule L durchsetzenden magnetischen Flusses bewirkt wird.

Um eine möglichst große induzierte Spannung zu erzielen beziehungsweise den Isolationsabstand zwischen der Mess-Spule L und dem elektrischen Leiter EL erforderlichenfalls vergrößern zu können, ist es weiterhin möglich, die Anzahl der Windungen beziehungsweise die Fläche der Mess-Spule L zu erhöhen beziehungsweise zu vergrößern und/oder die Amplitude der durch den mikroelektromechanischen Oszillator bewirkten Bewegung möglichst groß zu wählen.

Hinsichtlich ihrer Dimensionierung könnte die in Figur 2 dargestellte Anordnung beispielsweise so ausgelegt werden, dass bei einem elektrischen Leiter EL mit einer Breite von 2mm der Abstand zwischen der Mess-Spule L und der Oberfläche des elektrischen Leiters EL einen halben Millimeter beträgt. Dem entsprechend könnte die Mess-Spule L in der Darstellung der

Figur 2 eine horizontale Ausdehnung in der Größenordnung von 1mm aufweisen und die Amplitude der durch den mikroelektromechanischen Oszillator bewirkten zyklischen Bewegung beispielsweise einen halben Millimeter betragen. Es sei jedoch nachdrücklich darauf hingewiesen, dass es sich bei den genannten Werten lediglich um Beispiele handelt und in Abhängigkeit von den jeweiligen Anforderungen sowie dem jeweiligen Anwendungszweck auch Anordnungen mit hiervon gegebenenfalls deutlich abweichenden Werten denkbar sind.

Figur 3 zeigt eine weitere schematische Skizze zur weiteren Verdeutlichung des mikro-elektro-mechanisches Systems. Gezeigt ist hierbei eine perspektivische Darstellung einer im Wesentlichen der Figur 2 entsprechenden Anordnung, wobei zur besseren Veranschaulichung der Träger der Mess-Spule L weggelassen wurde. Erkennbar ist, dass die Mess-Spule L zwischen einem Hin- und einem Rückleiter in Form der Schenkel eines U-förmig ausgebildeten elektrischen Leiters EL bewegt wird, wobei die Bewegungsrichtung D wiederum durch einen entsprechenden Pfeil angedeutet ist. Die sich bei einem durch den elektrischen Leiter EL fließenden Strom I und dem durch diesen Strom I verursachten Magnetfeld in Bewegungsrichtung D ergebende Komponente des Magnetfeldes B ist als Hx bezeichnet als Funktion der Position x in Bewegungsrichtung D in dem Graphen G skizziert. Erkennbar ist, dass sich das Magnetfeld Hx in der Bewegungsrichtung D ändert, so dass sich bei einer Bewegung der Mess-Spule L in der Bewegungsrichtung D eine Änderung des die Mess-Spule L durchsetzende magnetischen Flusses ergibt. Hierdurch wird in der Mess-Spule L eine Spannung induziert, die eine Messgröße für den durch den elektrischen Leiter EL fließenden Strom I darstellt.

Um eine möglichst große Signalamplitude der induzierten Spannung zu erzielen, wird die Schwingungsfrequenz des mikroelektromechanischen Oszillators vorzugsweise im Bereich einiger Kilohertz bis in dem Megahertz Bereich gewählt werden. Dabei ist zu beachten, dass die Schwingungsfrequenz des mikroelektromechanischen Oszillators vorzugsweise derart gewählt wird, dass die spektralen Anteile des elektrischen Stromes I im Bereich der Betriebsfrequenz des mikroelektromechanischen Oszillators vernachlässigt werden können. Hierzu wird vorteilhafter Weise eine Bandpassfilterung mit geringer Bandbreite vorgesehen und die Betriebsfrequenz des mikroelektromechanischen Oszillators deutlich größer, d.h. beispielsweise um einen Faktor 10 bis 100 größer, gewählt als die im Spektrum des elektrischen Stromes I mit signifikanter Amplitude auftretenden maximalen Frequenzen. Dies bedeutet, dass sofern kein Gleichstrom sondern ein elektrischer Wechselstrom mit einer Frequenz von beispielsweise 1 kHz erfasst werden soll, hierfür vorzugsweise ein mikroelektromechanischer Oszillator verwendet wird, dessen Betriebsfrequenz im Bereich von zumindest 10 kHz liegt.

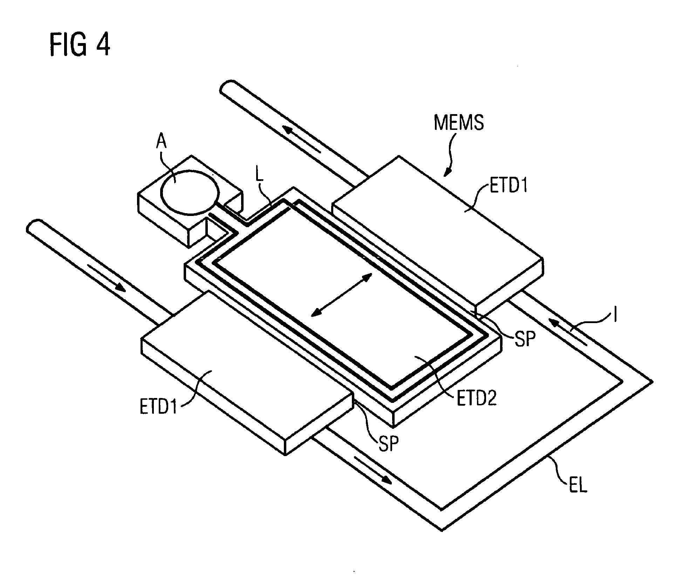

Figur 4 zeigt ein Ausführungsbeispiel mikroelektromechanischen Systems als Messgerät. Dargestellt ist ein mikroelektromechanisches System MEMS, das aus einem Anker A, einer Mess-Spule L, zwei ersten Elektroden ETD1 sowie einer zweiten Elektrode ETD2 besteht. Darüber hinaus ist in der in Figur 3 gezeigten Anordnung neben dem mikroelektromechanischen System MEMS ein U-förmiger elektrischer Leiter EL dargestellt. An dieser Stelle sei generell darauf hingewiesen, dass der elektrische Leiter EL grundsätzlich auch Bestandteil der eigentlichen Messvorrichtung sein kann. In diesem Fall wird ein zu messender Strom somit in den elektrischen Leiter EL eingeleitet, der in diesem Fall in der Messvorrichtung üblicherweise mit einem festen Abstand zum mikroelektromechanischen System MEMS angeordnet sein wird. Alternativ hierzu kann jedoch der elektrische Leiter EL auch Bestandteil einer beliebigen anderen Komponente sein, in welchem Fall die eigentliche Messvorrichtung den elektrischen Leiter EL somit nicht mit umfasst.

Bei dem in Figur 4 dargestellten mikroelektromechanischen System MEMS wird durch den Anker A sowie die ersten Elektroden ETD1 und die zweite Elektrode ETD2 ein mikroelektromechanischer Oszillator gebildet. Dabei ist der schwingfähige Teil des Oszillators, der durch die zweite Elektrode ETD2 gegeben ist, an dem Anker A aufgehängt. Zwischen der zweiten Elektrode ETD2 und den jeweiligen ersten Elektroden ETD1 befindet sich jeweils ein Luftspalt SP, dessen Breite üblicherweise im Mikrometerbereich liegen wird. Durch ein zyklisches Anlegen entsprechender Potenziale auf den Elektroden ETD1, ETD2 wird aufgrund wirkender elektrostatischer Kräfte ein mechanisches Schwingen der zweiten Elektrode ETD2 bewirkt, wobei die Bewegungsrichtung in Figur 4 durch den dargestellten Doppelpfeil angedeutet ist. Entsprechend der Darstellung ist eine Mess-Spule L, die in dem dargestellten Beispiel wiederum zwei Windungen aufweist, auf der zweiten Elektrode ETD2 befestigt, so dass mittels des mikroelektromechanischen Oszillators die' Mess-Spule L derart bewegt wird, dass aufgrund der Bewegung der Mess-Spule L in dem durch den elektrischen Strom I bewirkten Magnetfeld des elektrischen Leiters EL eine zyklische Änderung des die Mess-Spule L durchsetzenden magnetischen Flusses bewirkt wird. Hierdurch wird, wie zuvor bereits erläutert, eine Spannung in der Mess-Spule L induziert, die durch entsprechende Mittel erfasst werden und aus der der in dem elektrischen Leiter EL fließende Strom I ermittelt werden kann.

Es sei darauf hingewiesen, dass im Rahmen des erfindungsgemäßen mikroelektromechanischen Systems selbstverständlich auch mikroelektromechanische Oszillatoren verwendet werden können, die nach einem anderen als einem elektrostatischen Prinzip arbeiten. Darüber hinaus sei vorsorglich darauf hingewiesen, dass selbstverständlich auch eine Mess-Spule mit nur einer oder auch mehr als zwei Windungen verwendet werden kann.

Vorzugsweise kann das in Figur 4 dargestellte mikroelektromechanische System zusätzlich einen kapazitiven Spannungsmesser zum Erfassen der Spannung des elektrischen Leiters EL aufweisen. Ein entsprechendes mikroelektromechanisches System zur kapazitiven Spannungsmessung ist beispielsweise aus der zuvor bereits erwähnten WO 2005/121819 A1 bekannt. Vorzugsweise ist der Spannungsmesser hierbei an den mikroelektromechanischen Oszillator angekoppelt, so dass die durch den Oszillator bewirkte Bewegung nicht nur die Änderung des die Mess-Spule durchsetzenden magnetischen Flusses, sondern darüber hinaus auch eine im Rahmen der Spannungsmessung erforderliche Kapazitätsänderung bewirkt. Hierdurch wird vorteilhafterweise auf besonders einfache, kompakte und kostengünstige Art und Weise ein mikroelektromechanisches System zur Leistungsmessung, d.h. ein Wattmeter, bereitgestellt.

Entsprechend den vorstehend beschriebenen Ausführungsbeispielen weisen das erfindungsgemäße mikroelektromechanische System sowie das erfindungsgemäße Verfahren insbesondere den Vorteil auf, dass auf vergleichsweise einfache Art und Weise eine galvanisch getrennte sowie vielseitig einsetzbare Erfassung einer Messgröße für den durch den elektrischen Leiter fließenden Strom ermöglicht wird. Insbesondere dadurch, dass hierbei der zu messende, durch den elektrischen Leiter fließende elektrische Strom nicht selbst durch das mikroelektromechanische System zu fließen braucht, sind das mikroelektromechanische System sowie das Verfahren darüber hinaus, insbesondere auch hinsichtlich ihrer Anwendbarkeit bei vergleichsweise hohen Stromstärken, vorteilhafterweise besonders leistungsfähig.

Als magnetoresistive Effekte bezeichnet man alle Effekte, die die Änderung des elektrischen Widerstands eines Materials durch Anlegen eines äußeren Magnetfeldes beschreiben. Dazu gehören insbesondere der anisotrope magnetoresistive Effekt (AMR-Effekt), der "gigantische" magnetoresistive Effekt (GMR-Effekt), der CMR-Effekt, der TMR-Effekt sowie der planare Hall-Effekt.

## Patentansprüche

1. Verfahren zur Überwachung eines Schaltvorganges eines Schaltelementes (3) zum Schalten eines elektrischen Stromes (I) für einen Verbraucher (4), wobei
- zumindest ein individueller Verbrauchswert des Verbrauchers (4) ermittelt wird,
- der Verbrauchswert mit einem Referenzwert verglichen wird, **dadurch gekennzeichnet, dass**
- in Abhängigkeit eines Vergleichsergebnisses eine Vorhersage für eine maximale Schaltspielanzahl (N) gegeben wird.

2. Verfahren nach Anspruch 1, wobei ein zeitlicher Verlauf des Stromes (I) ermittelt wird.

3. Verfahren nach Anspruch 1 oder 2, wobei ein zeitlicher Verlauf einer Spannung (U) am Verbraucher ermittelt wird.

4. Verfahren nach Anspruch 3, wobei der zeitliche Verlauf des Stromes (I) und/oder der Spannung (U) abschnittsweise analysiert wird und eine Aussage über einen möglichen Verschleiß des Schaltelementes (3) gegeben wird.

5. Verfahren nach einem der Ansprüche 1 bis 4, wobei charakteristische Daten des Verbrauchers (4) ermittelt und gespeichert werden.

6. Verfahren nach einem der Ansprüche 1 bis 5, wobei das Erreichen einer vorgebbaren ersten Anzahl (n1) oder der maximalen Schaltspielanzahl (N) überwacht wird, und bei Überschreiten einer der beiden Anzahlen eine Warnung ausgegeben wird.

7. Verfahren nach Anspruch 6, wobei bei Überschreiten einer der beiden Anzahlen (N,n1) ein wiederholtes Schalten verhindert wird.

8. Verfahren nach einem der Ansprüche 1 bis 7, wobei zur kontaktlosen Messung des elektrischen Stromes (I) ein magnetoresistiver Sensor (11) eingesetzt wird.

9. Verfahren nach einem der Ansprüche 2 bis 8, wobei die Spannung (U) mit einem Mikro-Elektro-Mechanischen System (12) kontaktlos gemessen wird.

10. Vorrichtung (10) zur Überwachung eines Schaltvorganges eines Schaltelementes (3) zum Schalten eines elektrischen Stromes (I) für einen Verbraucher (4), umfassend
- ein Ermittlungsmittel (5) zum Ermitteln zumindest eines individuellen Verbrauchswertes des Verbrauchers (4),
- ein Vergleichsmittel (6) zum Vergleichen des zumindest einen Verbrauchswertes mit einem Referenzwert, **gekennzeichnet durch**
- ein Vorhersagemittel (7) zum Vorhersagen einer maximalen Schaltspielanzahl in Abhängigkeit des Vergleichsergebnisses.

11. Vorrichtung (10) nach Anspruch 10, wobei das Ermittlungsmittel (5) dazu ausgestaltet ist, einen zeitlichen Verlauf des Stromes (I) zu ermitteln.

12. Vorrichtung (10) nach Anspruch 10 oder 11, wobei das Ermittlungsmittel (5) dazu ausgestaltet ist, einen zeitlichen Verlauf einer Spannung (U) am Verbraucher zu ermittelt.

13. Vorrichtung (10) nach einem der Ansprüche 10 bis 12, aufweisend ein Speichermittel (8) zum abspeichern charakteristischer Daten des Verbrauchers (4).

14. Vorrichtung (10) nach einem der Ansprüche 10 bis 13, aufweisend einen magnetoresistiven Sensor (11) zur Messung der Spannung.

15. Vorrichtung (10) nach einem der Ansprüche 10 bis 14, aufweisend ein Mikro-Elektro-Mechanisches System (10) zum Messen der Spannung (U).

16. Relaisbaugruppe (1) mit einer Vorrichtung zur Überwachung eines Schaltvorganges eines Schaltelementes zum Schalten eines elektrischen Stromes (I) für einen Verbraucher (4) nach einem der Ansprüche 10 bis 15.

## Claims

1. Method for monitoring a switching process of a switching element (3) for switching an electrical current (I) for a consumer (4), with
- at least one individual consumption value of the consumer (4) being determined,
- the consumption value being compared with a reference value, **characterized in that**
- a prediction for a maximum number of switching cycles (N) being provided as a function of a comparison result.

2. Method according to claim 1, with a temporal progression of the current (I) being determined.

3. Method according to claim 1 or 2, with a temporal progression of a voltage (U) being determined at the consumer.

4. Method according to claim 3, with the temporal progression of the current (I) and/or the voltage (U) being analyzed section by section and information relating to a possible wear of the switching element (3) being given.

5. Method according to one of claims 1 to 4, with characteristic data of the consumer (4) being determined and stored.

6. Method according to one of claims 1 to 5, with the achievement of a presettable first number (n1) or the maximum number of switching cycles (N) being monitored and a warning being output if one of the two numbers is exceeded.

7. Method according to claim 6, with a repeated switching being prevented if one of the two numbers (N, n1) is exceeded.

8. Method according to one of claims 1 to 7, with a magnetoresistive sensor (11) being used for the contactless measurement of the electrical current (I).

9. Method according to one of claims 2 to 8, with the voltage (U) being measured in a contactless fashion with a micro-electro-mechanical system (12).

10. Apparatus (10) for monitoring a switching process of a switching element (3) for switching an electrical current (I) for a consumer (4), comprising
- a determination means (5) for determining at least one individual consumption value of the consumer (4),
- a comparison means (6) for comparing the at least one consumption value with a reference value, **characterized by**
- a prediction means (7) for predicting a maximum number of switching cycles as a function of the comparison result.

11. Apparatus (10) according to claim 10, with the determination means (5) being set up to determine a temporal progression of the current (I).

12. Apparatus (10) according to claim 10 or 11, with the determination means (5) being set up to determine a temporal progression of a voltage (U) at the consumer.

13. Apparatus (10) according to one of claims 10 to 12, comprising a storage means (8) for storing characteristic data of the consumer (4).

14. Apparatus (10) according to one of claims 10 to 13, comprising a magnetoresistive sensor (11) for measuring the voltage.

15. Apparatus (10) according to one of claims 10 to 14, comprising a micro-electro-mechanical system (10) for measuring the voltage (U).

16. Relay module (1) with an apparatus for monitoring a switching process of a switching element for switching an electrical current (I) for a consumer (4) according to one of claims 10 to 15.

## Revendications

1. Procédé de contrôle d'une opération de commutation d'un élément ( 3 ) de commutation pour appliquer un courant ( I ) électrique pour un utilisateur ( 4 ), dans lequel
- on détermine au moins une valeur individuelle d'utilisation de l'utilisateur ( 4 ),
- on compare la valeur d'utilisation à une valeur de référence,
**caractérisé en ce que**
- on donne une prédiction d'un nombre ( N ) maximun de commutations en fonction d'un résultat de la comparaison.

2. Procédé suivant la revendication 1, dans lequel on détermine une courbe du courant ( I ) en fonction du temps.

3. Procédé suivant la revendication 1 ou 2, dans lequel on détermine une courbe d'une tension ( U ) aux bornes de l'utilisateur en fonction du temps.

4. Procédé suivant la revendication 3, dans lequel on analyse la courbe en fonction du temps du courant ( I ) et/ou de la tension ( U ) par tronçon et on donne une prédiction sur une usure éventuelle de l'élément ( 3 ) de commutation.

5. Procédé suivant l'une des revendications 1 à 4, dans lequel on détermine et on mémorise des données caractéristiques de l'utilisateur ( 4 ).

6. Procédé suivant l'une des revendications 1 à 5, dans lequel on contrôle qu'un premier nombre ( n1 ) pouvant être prescrit ou le nombre ( N ) maximum de commutations est atteint et, si l'un des deux nombres est dépassé, on émet un avertissement.

7. Procédé suivant la revendication 6, dans lequel, si l'un des deux nombres ( N, n1 ) est dépassé, on empêche un renouvellement de la commutation.

8. Procédé suivant l'une des revendications 1 à 7, dans lequel on utilise un capteur ( 11 ) magnétorésistif pour la mesure sans contact du courant ( I ) électrique.

9. Procédé suivant l'une des revendications 2 à 8, dans lequel on mesure la tension ( U ) sans contact par un microsystème ( 12 ) électromécanique.

10. Dispositif ( 10 ) de contrôle d'une opération de commutation d'un élément ( 3 ) de commutation pour l'application d'un courant ( I ) électrique pour un utilisateur ( 4 ), comprenant
- un moyen ( 5 ) de détermination d'au moins une valeur individuelle d'une valeur d'utilisation de l'utilisateur ( 4 ),
- un moyen ( 6 ) de comparaison de la au moins une valeur d'utilisation à une valeur de référence, catactérisé par
- un moyen ( 7 ) de prédiction d'un nombre maximum de commutations en fonction du résultat de la comparaison.

11. Dispositif ( 10 ) suivant la revendication 10, dans lequel le moyen ( 5 ) de détermination est tel qu'il détermine une courbe en fonction du temps du courant ( I ).

12. Dispositif ( 10 ) suivant la revendication 10 ou 11, dans lequel le moyen ( 5 ) de détermination est tel qu'il détermine une courbe en fonction du temps d'une tension ( U ) aux bornes de l'utilisateur.

13. Dispositif ( 10 ) suivant l'une des revendications 10 à 12, comportant un moyen ( 8 ) de mémorisation pour mémoriser des données caractéristiques de l'utilisateur ( 4 ).

14. Dispositif ( 10 ) suivant l'une des revendications 10 à 13, ayant un capteur ( 11 ) magnétorésistif pour la mesure de la tension.

15. Dispositif ( 10 ) suivant l'une des revendications 10 à 14, ayant un microsystème ( 10 ) électromécanique de mesure de la tension ( U ) .

16. Module ( 1 ) formant relais et comprenant un dispositif de contrôle d'une opération de commutation d'un élément de commutation pour l'application d'un courant ( I ) électrique pour un utilisateur ( 4 ) suivant l'une des revendications 10 à 15.
